# EUROPEAN PATENT APPLICATION

(11) **EP 4 174 137 A1**
(43) Date of publication of application: **03.05.2023**
(21) Application number: 21833019.9
(22) Date of filing: 21.06.2021
(51) Int. Cl.: C08L 83/07, C08L 83/05, H01L 21/52, H01L 23/29, H01L 23/31

(54) **CURABLE SILICONE COMPOSITION AND CURED PRODUCT THEREFROM**

(30) Priority: 30.06.2020 JP 2020112615
(71) Applicant: Dow Toray Co., Ltd., Tokyo 140-8617 (JP)
(72) Inventor: YAMAZAKI Ryosuke, Ichihara-shi Chiba 299-0108 (JP); YAMAMOTO Shinichi, Ichihara-shi Chiba 299-0108 (JP); HAYASHI Masayuki, Ichihara-shi Chiba 299-0108 (JP)
(74) Representative: Murgitroyd & Company
(86) International application number: PCT/JP2021/023400
(87) International publication number: WO 2022/004464

(57) **Abstract**

[Problem]

To provide: a curable silicone composition that can be handled as a liquid at room temperature, where a cured product thereof has excellent adhesive and mechanical properties and exhibits relatively high hardness; and an application thereof.

[Resolution Means]

A curable silicone composition containing (A1) an organopolysiloxane resin having a curing reactive functional group that contains a carbon-carbon double bond, (A2) an organopolysiloxane resin not having the curing reactive functional group, and (B) a linear organopolysiloxane in a liquid state at 25°C having the curing reactive functional group, in specific mass% ranges, as well as (C) a curing agent, wherein the viscosity of the entire composition is 50 Pa·s or less, and the amount of the curing reactive functional groups in 100 g of the composition is 1.5 mol% or more; a cured product thereof; and a use thereof in a semiconductor application and the like.

## Description

### TECHNICAL FIELD

The present invention relates to: a curable silicone composition that can be handled as a liquid at room temperature and form a cured product with excellent adhesive and mechanical strength upon curing; and a cured product thereof. The present invention further relates to an application of the composition or cured product (particularly including a semiconductor device or the like having a semiconductor member, an optical semiconductor device member, or other member for a semiconductor and the cured product).

### [BACKGROUND ART]

Curable silicone compositions can be cured to form cured products having excellent heat resistance, cold resistance, electrical insulation, weather resistance, water repellency, and transparency, and are utilized in a wide range of industrial fields. In general, a cured product of such curable silicone compositions is less prone to discoloration compared with other organic materials and has reduced deterioration of physical properties overtime, and therefore is also suitable as a sealing agent for optical materials and semiconductor devices.

For example, Patent Document 1 and Patent Document 2 propose curable silicone compositions that form silicone elastomers with relatively high hardness, containing an alkenyl group-containing linear polyorganosiloxane, alkenyl group-containing resinous polyorganosiloxane, silicon-bonded hydrogen group-containing polyorganosiloxane, and a curing catalyst. However, while these silicone compositions exhibit favorable adhesion to common base materials such as aluminum and the like, there is a problem in which little adhesion is exhibited to difficult-to-adhere base materials such as those represented by polyphenylsulfone resin.

On the other hand, Patent Document 3 proposes a silicone pressure-sensitive adhesive containing an alkenyl group-containing linear polyorganosiloxane, resinous polyorganosiloxane not containing an alkenyl group, silicon-bonded hydrogen group-containing polyorganosiloxane, and a curing catalyst. These silicone compositions are known to exhibit excellent adhesion to various base materials, but resulting cured products are known to be very soft.

Furthermore, Patent Document 4 proposes an invention in which a small amount of resinous polyorganosiloxane that does not contain an alkenyl group is added to a paste-like curable silicone composition containing an alkenyl group-containing linear polyorganosiloxane, silicon-bonded hydrogen group-containing polyorganosiloxane, an inorganic filler, and a curing catalyst to lower the viscosity. However, the amount of resinous polyorganosiloxane without alkenyl groups added is too small to obtain a curable silicone composition that exhibits excellent adhesion as indicated in Patent Document 3.

Next, Patent Document 5 discloses a hot-melt curable silicone sheet containing an alkenyl group-containing linear polyorganosiloxane, resinous polyorganosiloxane without alkenyl groups, alkenyl group-containing resinous polyorganosiloxane, silicon-bonded hydrogen group-containing polyorganosiloxane, and a curing catalyst. The present composition is expected to form a cured product with a certain degree of hardness and to have excellent adhesion. However, due to the nature thereof, these compositions are solids at room temperature and cannot be handled as liquids, making use in applications where a liquid form is required impossible. As described above, there is no known silicone composition that can be handled as a liquid at room temperature and has both excellent adhesive properties as in silicone pressure-sensitive adhesives and hardness in an elastomer region.

### RELATED ART DOCUMENTS

### PATENT DOCUMENTS

Patent Document 1: Japanese Unexamined Patent Application 2012-12433
Patent Document 2: Japanese Unexamined Patent Application 2012-12434
Patent Document 3: Japanese Unexamined Patent Application H7-197008
Patent Document 4: Japanese Unexamined Patent Application H7-179764
Patent Document 5: Japanese PCT Patent Application 2017-512224

### SUMMARY OF THE INVENTION

### PROBLEM TO BE SOLVED BY THE INVENTION

In view of the foregoing, an object of the present invention is to provide: a curable silicone composition that can be handled as a liquid at room temperature, where a cured product thereof has excellent adhesive and mechanical properties and exhibits relatively high hardness; and an application thereof.

### MEANS FOR SOLVING THE PROBLEM

As a result of extensive research, the present inventors discovered that the aforementioned problems can be solved by a curable silicone composition containing an organopolysiloxane resin having a curing reactive functional group that contains a carbon-carbon double bond, an organopolysiloxane resin not having the curing reactive functional group, and a linear organopolysiloxane in a liquid state at 25°C having a curing reactive functional group, in specific mass% ranges, as well as a curing agent, wherein the viscosity of the entire composition is 50 Pa·s or less, and the amount of the curing reactive functional groups in 100 g of the composition is 1.5 mol% or more. The problems can also be solved by a cured product of the composition, and a use of the cured product in a semiconductor application or the like; thus, the present invention was achieved.

From the perspective of the technical effect of the present invention, the organopolysiloxane resin having a curing reactive functional group containing a carbon-carbon double bond as described above particularly preferably has a weight average molecular weight that is at a certain level or lower, an amount of alkenyl groups in a molecule that is at a certain amount or higher, and a component ratio of siloxane units forming the organopolysiloxane resin that is within a certain range. Furthermore, the composition preferably is curable by a hydrosilylation reaction. Furthermore, a cured product obtained by curing the composition according to the present invention can be preferably used as a semiconductor member.

### EFFECTS OF THE INVENTION

The curable silicone composition of the present invention is a liquid at room temperature and is applicable to processes that can only be used with liquid compositions, such as dispensing applications and the like. On the other hand, a resulting cured product exhibits favorable adhesion to various base materials, particularly to so-called difficult-to-adhere base materials such as polyphenylene sulfone resins and the like, and therefore can be applied to base materials, processes, and applications in which application is difficult with conventional, general silicone elastomer forming compositions. In addition, the cured product obtained by curing the present composition demonstrates sufficient mechanical strength and elastomeric hardness, and therefore can be used not only as an adhesive to adhere two base materials, but also as a sealing agent or protective material to protect the base materials. Note that the curable silicone composition of the present invention can optionally be supplemented with various inorganic and functional fillers while maintaining the advantageous properties described above, and a resulting cured product can be further provided with special functions such as thermal conductivity, light reflectivity, and the like. Therefore, the cured product is extremely useful as a semiconductor member.

### DESCRIPTION OF THE PREFERRED EMBODIMENT

Embodiments of the present invention will be described below in detail.

### [Curable Silicone Composition]

The curable silicone composition according to the present invention at least contains:
(A1) an organopolysiloxane resin having a curing reactive functional group with a carbon-carbon double bond included in a molecule, and containing a siloxane unit expressed by RSiO_{3/2} (R represents a monovalent organic group, hydroxyl group or alkoxy group) or SiO_{4/2} making up at least 20 mol% of all siloxane units;
(A2) an organopolysiloxane resin having a curing reactive functional group with a carbon-carbon double bond included in a molecule, and containing a siloxane unit expressed by SiO_{4/2} making up at least 20 mol% or more of the total siloxane units;
(B) a linear organopolysiloxane in a liquid state at 25°C, having a curing reactive functional group containing at least two carbon-carbon double bonds in a molecule; and
(C) one or more type of a curing agent required for curing the present composition; wherein
   the viscosity of the entire composition is 50 Pa·s or less, and the amount of curing reactive functional groups containing a carbon-carbon double bond in 100 g of the composition is 1.5 mol% or more. The composition may be supplemented with one or more type of filler selected from reinforcing fillers, white pigments, thermally conductive fillers, electrically conductive fillers, and organic fillers, as necessary, to add further functionality to a cured product thereof.

Furthermore, other additives may be added so long as the technical effect of the present invention is not impaired.

### [Organopolysiloxane Resin (A1) Having a Curing Reactive Functional Group]

Component (A1) above is one of the main agents of the present composition and is an organopolysiloxane resin having a curing reactive functional group with a carbon-carbon double bond included in a molecule and containing a siloxane unit expressed by RSiO_{3/2} or SiO_{4/2}, which are branch units, making up at least 20 mol% or more of the total siloxane units. Herein, R represents a monovalent organic group, a hydroxyl group or an alkoxy group, and is preferably selected from curing reactive groups with a carbon-carbon double bond described below, monovalent hydrocarbon groups with 1 to 10 carbon atoms without a carbon-carbon double bond, hydroxyl groups, or alkoxy groups with 1 to 10 carbon atoms.

The curing reactive group having a carbon-carbon double bond may be a functional group having a carbon-carbon double bond such as a (meth)acryloxy group or the like, but is particularly preferably a hydrosilylation reactive functional group. Such a functional group can form a cured product when component (C) described later is a curing agent that is an organohydrogenpolysiloxane and a hydrosilylation reaction catalyst. Examples of such a curing reactive group include alkenyl groups with 2 to 10 carbons, and is particularly preferably a vinyl group or 1-hexenyl group.

Preferably, the amount of alkenyl groups in component (A1) is 1 to 50 mol%, preferably 2 to 45 mol%, and more preferably 2 to 35 mol% of all silicon-bonded organic groups. By setting the amount of alkenyl groups in component (A1) within the range above, relatively high hardness can be imparted to a resulting cured product even when the raw material ratio of component (A1) in the present composition is small.

Component (A1) may contain other functional groups that do not have a carbon-carbon double bond, and in particular, preferably contains a monovalent hydrocarbon group with 1 to 10 carbon atoms that does not have a carbon-carbon double bond, and particularly preferably contains an alkyl group with 1 to 10 carbon atoms such as a methyl group or the like. On the other hand, if a transparent composition is desired, component (A1) has a percentage of phenyl groups and other aryl groups in the total silicon-bonded organic groups within a range of 0 to 5 mol%, more preferably within a range of 0 to 2 mol%, and most preferably does not contain aryl groups (= 0 mol%).

Preferably, the functional group bonded to the silicon atom in component (A1) is a group selected from methyl groups, vinyl groups and other alkenyl groups, and 50 to 99 mol% of all silicon-bonded organic groups are preferably methyl groups, 55 to 98 mol% of all organic groups bonded to silicon atoms are more preferably methyl groups, and 65 to 98 mol% of all silicon-bonded organic groups are particularly preferably methyl groups, with any other functional group bonded to a silicon atom being a vinyl group or other alkenyl group. In such a range, component (A1) has higher mutual solubility with other components, and coloring resistance and the like of a resulting cured product at high temperatures is improved. Note that a small amount of hydroxyl groups or alkoxy groups may be included in component (A1).

Component (A1) contains a siloxane unit expressed by RSiO_{3/2} or SiO_{4/2}, which are branch units, making up at least 20 mol% or more of the total siloxane units, preferably the RSiO_{3/2} or SiO_{4/2}, which are branch units, make up least 40 mol% or more of the total siloxane units, more preferably 50 mol% or more, and particularly preferably they are within a range of 50 to 90 mol%. Note that R preferably represents a monovalent organic group, and particularly preferably a methyl group from the perspective of compatibility with other components.

Preferably, component (A1) is
(A1-1) an organopolysiloxane resin expressed by the following average unit formula:

   (R¹3SiO_{1/2})a(R¹₂SiO_{2/2})b(R¹SiO_{3/2})c(SiO_{4/2})d(R²O_{1/2})ₑ
(where each R¹ independently represents a monovalent hydrocarbon group with 1 to 10 carbon atoms, but 1 to 50 mol% of all R¹s in a molecule represents an alkenyl group; each R² represents a hydrogen atom or an alkyl group with 1 to 10 carbon atoms; and a, b, c, d, and e represent numbers that satisfy 0.10 ≤ a ≤ 0.90, 0 ≤ b ≤ 0.70, 0 ≤ c ≤ 0.80, 0 ≤ d ≤ 0.65, 0 ≤ e ≤ 0.05, but c + d > 0.20 and a + b + c + d = 1).

In the aforementioned average unit formula, each R¹ independently represents a monovalent hydrocarbon group having 1 to 10 carbon atoms, such as groups selected from a group consisting of: methyl groups and other alkyl groups with 1 to 10 carbon atoms, particularly preferably methyl groups; vinyl groups and other alkenyl groups with 2 to 10 carbon atoms; phenyl groups and other aryl groups; and benzyl groups and other aralkyl groups. Furthermore, 2 to 45 mol% of all R¹s in one molecule are alkenyl groups, and 2 to 35 mol% of all R¹s in one molecule are preferably alkenyl groups, and particularly preferably vinyl groups and/or 1-hexenyl groups. If the alkenyl group content is less than the lower limit of the range described above, the mechanical strength (hardness, and the like) of the resulting cured product may be insufficient. On the other hand, if the amount of alkenyl groups is at or below the upper limit of the range above, a composition containing the present component can form a cured product with excellent mechanical strength. Note that each R¹ preferably represents a functional group selected from the alkyl groups and alkenyl groups above, but from the perspective of the technical effect of the present invention, the R¹ preferably does not substantially contain a phenyl group or other aryl group.

In the formula above, R² represents a hydrogen atom or an alkyl group having or 1 to 10 carbon atoms. The group R²O_{1/2} containing the R² corresponds to a hydroxyl group or alkoxy group of the organopolysiloxane resin of component (A1).

In the formula, "a" represents a number indicating the percentage of siloxane units in the general formula: R¹₃SiO_{1/2}. "a" satisfies 0.1 ≤ a ≤ 0.90, and preferably satisfies 0.15 ≤ a ≤ 0.85. If "a" is within the range above, a composition containing the present component can form a cured product with excellent mechanical strength.

In the formula, "b" represents a number indicating the percentage of siloxane units in the general formula: R¹₂SiO_{2/2}. "b" satisfies 0 ≤ b ≤ 0.70, and preferably satisfies 0 ≤ b ≤ 0.60. If "b" is at or below the upper limit of the range above, it is possible to obtain a composition in which the viscosity of the composition containing the present component does not become too high.

In the formula, "c" represents a number indicating the percentage of siloxane units in the general formula: R³SiO_{3/2}. "c" satisfies 0 ≤ c ≤ 0.80, and preferably satisfies 0 ≤ c ≤ 0.75. If "c" is at or below the upper limit of the range above, it is possible to obtain a composition in which the viscosity of the composition containing the present component does not become too high and the mechanical strength of a resulting cured product is excellent. In the present invention, "c" may be 0 and is preferably 0.

In the formula above, "d" represents a number indicating the percentage of siloxane units with the formula SiO_{4/2}, and must satisfy the condition 0.00 ≤ d ≤ 0.65, preferably satisfies 0.15 ≤ d ≤ 0.65, and particularly preferably satisfies 0.20 ≤ d ≤ 0.65. If "d" is within the numerical value range above, it is possible to obtain a composition in which the viscosity of the composition containing the present component does not become too high and the mechanical strength of a resulting cured product is excellent.

In the present invention, "c" or "d" in the aforementioned formula may be 0, but must satisfy c + d > 0.20. If the value of c + d is 0.20 or less, the hardness of a resulting cured product cannot be increased, and a technical effect of the present invention may not be sufficiently achieved.

In the formula above, "e" is a number indicating the percentage of units in the general formula: R²O_{1/2}, where the units are a hydroxyl group or alkoxy group bonded to a silicon atom that can be contained in the organopolysiloxane resin. "e" satisfies 0 ≤ e ≤ 0.05, preferably 0 ≤ e ≤ 0.03. Note that in the formula above, the sum of "a", "b", "c" and "d", which is the sum of each siloxane unit, is equal to 1.

Component (A1) is an organopolysiloxane resin having the characteristics above, which may be liquid or solid at room temperature, but whose weight average molecular weight (Mw) as measured by gel permeation chromatography (GPC) using toluene as a solvent is 15,000 or less, more preferably 10,000 or less, and particularly preferably within a range of 100 to 10,000. The viscosity of the overall composition can be reduced by using component (A1) of a relatively low molecular weight.

The added amount of component (A1) must be within a range of 1 to 50 mass% of the total amount (100 mass%) of components (A1), (A2), and (B). The range is preferably 1 to 45 mass%, and more preferably 1 to 40 mass%. By setting the amount of component (A1) added in this range, it is possible to balance the adhesive properties, mechanical strength, and hardness of the cured product obtained from the composition of the present invention. In particular, when the molecular weight and amount of alkenyl groups of component (A1) are within the preferred range above, the overall viscosity of the composition and the amount of component (A1) added can be controlled and the relative added amount of component (A2) can be increased, which further improves the adhesion and mechanical strength, which is represented by the hardness of the cured product.

### [Organopolysiloxane Resin (A2) Without a Curing Reactive Functional Group]

Component (A2) is one of the main agents of the present composition and is an organopolysiloxane resin having a curing reactive functional group with a carbon-carbon double bond included in a molecule, and containing a siloxane unit expressed by SiO_{4/2} making up at least 20 mol% or more of the total siloxane units. By using component (A2) in combination with component (A1) and component (B) within a prescribed quantitative range, it is possible to achieve a low viscosity for the curable silicone composition as a whole and to achieve excellent adhesive properties and mechanical strength of a cured product obtained by curing the curable silicone composition. Furthermore, the hardness of the resulting curable silicone composition after curing can be adjusted by using it in combination with component (A1) having a curing reactive functional group.

Component (A2) does not contain a curing reactive functional group containing a carbon-carbon double bond such as an alkenyl group or the like in a molecule, while preferably containing a monovalent hydrocarbon group with 1 to 10 carbon atoms without a carbon-carbon double bond, and particularly preferably a functional group selected from methyl groups and other alkyl groups with 1 to 10 carbon atoms, and aryl groups. On the other hand, component (A2) preferably has a percentage of phenyl groups and other aryl groups in the total silicon-bonded organic groups within a range of 0 to 5 mol%, more preferably within a range of 0 to 2 mol%, and most preferably does not contain aryl groups (= 0 mol%). If the amount of aryl groups in component (A2) exceeds the upper limit above, component (A2) becomes hot-meltable, making it difficult to obtain a desired liquid composition, a reinforcing effect of a cured product derived from siloxane units expressed by SiO_{4/2} in a molecule may decrease, and the coloring resistance of the cured product under high temperature may deteriorate.

Preferably, 70 to 100 mol% of the silicon-bonded organic groups in component (A2) are preferably methyl groups, 80 to 100 mol% are more preferably methyl groups, and 88 to 100 mol% are particularly preferably methyl groups. In such a range, component (A2) can be a component that has a particularly excellent reinforcing effect for cured products containing siloxane units expressed by SiO_{4/2}. Note that the organopolysiloxane resin of component (A2) may contain a small amount of hydroxyl groups or alkoxy groups.

Component (A2) is an organopolysiloxane resin and contains a siloxane unit that is a branched siloxane unit expressed by SiO_{4/2} making up at least 20 mol% or more of the total siloxane units in the molecule. Preferably, the SiO_{4/2} unit of the organopolysiloxane of component (A2) is at least 40 mol%, more preferably 50 mol% or more, and particularly preferably within a range of 50 to 65 mol% of all siloxane units.

Preferably component (A2) is (A2-1) an organopolysiloxane resin expressed by the following average unit formula:

(R³₃SiO_{1/2})_{f}(R³₂SiO_{2/2})_{g}(R³SiO_{3/2})ₕ(SiO_{4/2})ᵢ(R²O_{1/2})ⱼ

(where each R³ independently represents a monovalent hydrocarbon group with 1 to 10 carbon atoms and that does not contain a carbon-carbon double bond; R² represents a hydrogen atom with an alkyl group with 1 to 10 carbon atoms; and f, g, h, i, and j represents numbers that satisfy 0.35 ≤ f ≤ 0.55, 0 ≤ g ≤ 0.20, 0 ≤ h ≤ 0.20, 0.30 ≤ i ≤ 0.65, 0 ≤ j ≤ 0.05, and f + g + h + i = 1).

In the average unit formula above, R² represents the same group as above, and is preferably a hydrogen atom or a methyl group. R³ independently represents a monovalent hydrocarbon group having 1 to 10 carbon atoms and containing no carbon-carbon double bond, such as a methyl group or other alkyl group. Herein, it is particularly preferred from the perspective of industrial production and the technical effect of the invention that 70 mol% or more, and more preferably 88 mol% or more of the total R³ in one molecule is a methyl group or other alkyl group with 1 to 10 carbon atoms, and particularly a methyl group. On the other hand, R³ is preferably substantially free of phenyl groups and other aryl groups.

In the formula, "f" represents a number indicating the percentage of siloxane units in the general formula: R³₃SiO_{1/2}. "f" satisfies 0.35 ≤ f≤ 0.55, and preferably 0.40 ≤ f ≤ 0.50. If "f" is within the range above, a cured product made of the curable silicone composition containing the present component can be provided with excellent adhesive properties and mechanical strength.

In the formula, "g" represents a number indicating the percentage of siloxane units in the general formula: R¹₂SiO_{2/2}. "g" satisfies 0 ≤ g ≤ 0.20, and preferably 0 ≤ g ≤ 0.10. If "g" is at or below the upper limit of the range, the viscosity of the curable silicone composition containing the present component does not become too high. In the present invention, "g" may be 0 and is preferably 0.

In the formula, "h" represents a number indicating the percentage of siloxane units in the general formula: R₁SiO_{3/2}. "h" satisfies 0 ≤ h ≤ 0.20, and preferably 0 ≤ h ≤ 0.10. If "h" is at or below the upper limit of the range, the viscosity of the curable silicone composition containing the present component does not become too high and a resulting cured product can be provided with excellent mechanical strength. In the present invention, "h" may be 0 and is preferably 0.

In the formula above, "i" represents a number indicating the percentage of SiO_{4/2} siloxane units, and preferably satisfies 0.30 ≤ i ≤ 0.65, and particularly preferably satisfies 0.50 ≤ i ≤ 0.65. If "i" is within the numerical value range, a cured product obtained by curing the curable silicone composition containing the present component can be provided with excellent adhesion and mechanical strength.

In the formula above, "i" is a number indicating the percentage of units of the general formula: R²O_{1/2}, where the units are a hydroxyl group or alkoxy group bonded to a silicon atom that can be contained in the organopolysiloxane resin. "j" satisfies 0 ≤ j ≤ 0.05, preferably 0 ≤ j ≤ 0.03. Note that in the formula above, the sum of "f", "g", "h" and "i", which is the sum of each siloxane unit, is equal to 1.

Component (A2) is an organopolysiloxane resin having the characteristics above, which may be liquid or solid at room temperature, but whose weight average molecular weight (Mw) as measured by GPC using toluene as a solvent is preferably 15,000 or more, and particularly preferably within a range of 15,000 to 100,000, from the perspective of being able to provide a cured product containing the present composition with excellent adhesive properties and mechanical strength.

The added amount of component (A2) is within a range of 20 to 70 mass%, and preferably 25 to 60 mass% of the total amount (100 mass%) of components (A1), (A2), and (B).

Furthermore, in terms of balancing the properties of the overall composition of the present invention, a design technique is preferred in which component (A2) has a relatively high molecular weight and is added in a large amount relative to the total amount of components (A1), (A2), and (B) to provide a resulting cured product with excellent adhesive properties and mechanical strength, while adding a small amount of component (A1), which has a relatively low molecular weight and contains a large amount of curing reactive groups, to reduce the viscosity of the overall composition and increase the hardness and the like of a resulting cured product.

### [Component (B)]

Component (B) is one of the main agents of the present curable silicone composition, and is a linear organopolysiloxane that is liquid at 25°C and has a curing reactive functional group containing at least two carbon-carbon double bonds in a molecule. Such a curing reactive chain organopolysiloxane can be used in combination with the aforementioned component (A1) or component (A2), which are organopolysiloxane resins, to provide mechanical strength to a resulting cured product.

Component (B) must have a curing reactive functional group having a carbon-carbon double bond in a molecule. Such a curing reactive functional group is hydrosilylation reactive, and forms a cured product by a cross-linking reaction with another component. Such a curing reactive functional group is preferably an alkenyl group similar to that provided by component (A1), and particularly preferably a vinyl group or hexenyl group.

Component (B) is a linear organopolysiloxane that is liquid at 25°C (room temperature) and plays an important role in reducing the viscosity of the composition of the present invention. The chemical structure of the organopolysiloxane of component (B) is preferably
(B1) a linear diorganopolysiloxane expressed by
the following structural formula (B1):

   R⁴₃SiO(SiR⁴₂O)ₖSiR⁴₃
(where each R⁴ independently represents a monovalent hydrocarbon group with 1 to 10 carbon atoms, but at least two of the R⁴s in one molecule represents an alkenyl group, and k represents a number from 20 to 1,000). A linear diorganopolysiloxane having an alkenyl group, and particularly preferably a vinyl group at both ends of a molecular chain is preferred.

In the formula above, each R⁴ independently represents a monovalent hydrocarbon group having 1 to 10 carbon atoms, such as groups selected from a group consisting of: methyl and other alkyl groups, and particularly preferably methyl groups; vinyl and other alkenyl groups, and particularly preferably vinyl groups and/or hexenyl groups; phenyl and other aryl groups; and benzyl and other aralkyl groups. Furthermore, at least two of the R⁴ in one molecule are alkenyl groups, and preferably a vinyl group. Furthermore, each R⁴ is preferably a functional group selected from a group consisting of methyl groups and other alkyl groups having 1 to 10 carbon atoms and vinyl groups, hexenyl groups and other alkenyl groups, and it is preferable that of all R⁴s, at least two are alkenyl groups per molecule, and the remaining R⁴ are methyl groups. Note that from the perspective of a technical effect of the invention, R⁴ is preferably substantially free of phenyl groups and other aryl groups. If a large amount of phenyl groups or other aryl groups are included, the coloring resistance at high temperatures of the cured product obtained from the curable silicone composition may deteriorate. Particularly preferably, a vinyl group or other alkenyl group is preferred at both ends of a molecular chain, with the rest of R⁴ being a methyl group.

In the formula above, k represents a number between 20 and 1,000 preferably between 30 and 800, and particularly preferably between 30 and 500. If k is at or above the lower limit of the above range, a resulting cured product can be provided with sufficient mechanical properties. On the other hand, if k is at or below the upper limit of the range above, an increase in the viscosity of the overall curable silicone composition can be suppressed.

Herein, the added amount of component (B) is within a range of 15 to 70 mass%, preferably 20 to 65 mass%, and more preferably 20 to 60 mass% of the total amount (100 mass%) of components (A1), (A2), and (B). By setting the added amount of component (B) to be in this range, it is possible to balance the viscosity of the composition of the present invention and the mechanical strength and hardness of a resulting cured product.

### [Component (C)]

Component (C) is a curing agent for curing component (A1) and component (B) described above, and is specifically one or more curing agent selected from (c1) or (c2) below. Two or more of these curing agents may be used in combination, for example, the cure system may include both a (c1) component and a (c2) component.
(c1) an organic peroxide; and
(c2) an organohydrogenpolysiloxane having at least two silicon atom-bonded hydrogen atoms per molecule and a hydrosilylation reaction catalyst; and
(c1) Organic peroxide is a component that cures component (A) and component (B) described above by heating, and examples include alkyl peroxides, diacyl peroxides, ester peroxides, and carbonate peroxides. component (c1) can also react with some of the (A2) components. Furthermore, the organic peroxide preferably has a 10-hour half-life temperature of 90°C or higher or 95°C or higher. Examples of such organic peroxide include dicumyl peroxide, di-tert-butyl peroxide, di-tert-hexyl peroxide, tert-butylcumyl peroxide, 2,5-dimethyl-2,5-di(tert-butylperoxy)hexane, 1,3-bis(tert-butylperoxyisopropyl)benzene, di-(2-tert-butylperoxyisopropyl)benzene, and 3,6,9-triethyl-3,6,9-trimethyl-1,4,7-triperoxonan.

While not limited thereto, the amount of the organic peroxide (c1) is preferably within a range of 0.05 to 10 mass parts, or within the range of 0.10 to 5.0 mass parts, relative to the total (100 mass parts) of component (A1), component (A2), and component (B).

The organohydrogenpolysiloxane having at least two silicon-bonded hydrogen atoms in the (c2) molecule and the hydrosilylation reaction catalyst are components that cure the composition by an addition reaction (hydrosilylation reaction) of the organohydrogenpolysiloxane, which is a crosslinking agent, with the carbon-carbon double bond in component (A1) and component (B) in the presence of the hydrosilylation reaction catalyst.

The structure of the crosslinking agent, organohydrogenpolysiloxane, is not particularly limited and may be straight-chain, branched-chain, cyclic, or resinous. In other words, component (c2) may be an organohydrogenpolysiloxane having, as a main constituent unit, a hydrogen organosiloxy unit expressed by HR₂SiO_{1/2} (D^{H} unit, where R independently represents a monovalent organic group), and at the end thereof a hydrogendiorganosiloxy unit expressed by HR₂SiO_{1/2} (M^{H} unit, where R independently represents a monovalent organic group). In particular, in the case of applications other than the molding process described below, even if the curable silicone composition is a chain-like organohydrogenpolysiloxanes made up of the D^{H} units described above, or the like, sufficient curing is possible for practical use.

On the other hand, when the curable silicone composition is used in a molding process, since the amount of the curing reactive functional group containing a carbon-carbon double bond in the present composition is small, from the perspective of curing rate, moldability, and curing curability thereof, the organohydrogenpolysiloxane is preferably an organohydrogenpolysiloxane resin containing a monoorganosiloxy unit expressed by RSIO_{3/2} (T unit, where R represents a monovalent organic group or a silicon-bonded hydrogen atom) or a branch unit of a siloxy unit (Q unit) expressed by SiO_{4/2}, having at least two hydrogendiorganosiloxy units expressed by HR₂SiO_{1/2} (M^{H} unit, where R independently represents a monovalent organic group), and having the M^{H} unit at a molecular terminal.

A particularly preferred organohydrogenpolysiloxane is an organohydrogenpolysiloxane resin expressed by the following average unit formula:

(R⁵₃SiO_{1/2})ₗ(R⁶₂SiO_{2/2})ₘ(R⁶SiO_{3/2})ₙ(SiO_{4/2})ₚ(R²O_{1/2})_{q}

In the formula, each R⁵ is the same or different hydrogen atom or monovalent hydrocarbon group having 1 to 10 carbon atoms without an aliphatic unsaturated carbon bond, where at least two R⁵ in one molecule are hydrogen atoms. A monovalent hydrocarbon group corresponding to R⁵, excluding hydrogen atoms, includes, for example: methyl and other alkyl groups; phenyl and other aryl groups; benzyl and other aralkyl groups; other halogenated alkyl groups; and the like. From an industrial viewpoint, methyl groups or phenyl groups are preferred.

In the formula, R⁶ represents a monovalent hydrocarbon group with 1 to 10 carbon atoms without an aliphatic unsaturated carbon bond, and examples include the same groups as the monovalent hydrocarbon group described above. On the other hand, R² is a hydrogen atom or an alkyl group having 1 to 10 carbon atoms, for example, R² in the above component (A1) or component (A2).

In the formula, I, m, n, and p are numbers that satisfy the following: 0.1 ≤ l ≤ 0.80, 0 ≤ m ≤ 0.5, 0 ≤ n ≤ 0.8, 0 ≤ p ≤ 0.6, 0 ≤ q ≤ 0.05, wherein n + p > 0.1 and ! + m + n + p = 1. Herein, when the present composition is used in the molding process, the organohydrogenpolysiloxane resin serving as a part of component (d2) is specifically preferably a M^{H}MT resin, M^{H}MTTH resin, M^{H}MTQ resin, M^{H}MQ resin, M^{H}MTT^{H}Q, or M^{H}Q resin.

A particularly preferably organohydrogenpolysiloxane serving as a part of component (c2) is an M^{H}Q resin expressed by:

(H(CH₃)₂SiO_{1/2})ₗ₁ (SiO_{4/2})ₚ₁

Here, l1 + p1 = 1, and it is preferable to have 0.1 ≤ l1 ≤ 0.80 and 0.20 ≤ p1 ≤ 0.90.

Similarly, the organohydrogenpolysiloxane that is part of component (c2) may include straight-chain diorganopolyoxane, organohydrogenpolysiloxane, or diorganopolysiloxane whose molecular chain ends are capped by silicon-bonded hydrogen atoms or trimethylsiloxy groups. The degree of polymerization of siloxane of these straight-chain organohydrogenpolysiloxanes is not particularly limited, but is in the range of 2 to 200, and is preferably in the range of 5 to 100.

The amount of the organohydrogenpolysiloxane, which is a part of component (c2), is an amount sufficient to cure the curable silicone composition of the present invention, and the molar ratio of the silicon-bonded hydrogen atom in the organohydrogenpolysiloxane is 0.9 or more and preferably in the range of 0.9 to 2.0 relative to the curing reactive functional group (for example, a vinyl group or other alkenyl group) containing a carbon-carbon double bond in component (A1) and component (B).

Examples of the hydrosilylation reaction catalyst serving as a part of component (c2) include platinum-based catalysts, rhodium-based catalysts, and palladium-based catalysts. Platinum-based catalysts are preferred due to the ability to remarkably promote curing of the present composition. Exemplary platinum-based catalysts include platinum fine powder, chloroplatinic acid, an alcohol solution of chloroplatinic acid, a platinum-alkenyl siloxane complex, a platinum-olefin complex, a platinum-carbonyl complex, and a catalyst in which these platinum-based catalysts are dispersed or encapsulated with a thermoplastic resin such as silicone resin, polycarbonate resin, acrylic resin, or the like, with a platinum-alkenyl siloxane complex particularly preferable. In particular, a 1,3-divinyl-1,1,3,3-tetramethyldisiloxane complex of platinum is preferred, and is preferably added in the form of an alkenylsiloxane solution of the complex. In addition, in terms of improving the handleability as well as the pot life of the composition, a platinum containing hydrosilylation reaction catalyst in microparticles dispersed and encapsulated with thermoplastic resin may be used. As the catalyst for promoting the hydrosilylation reaction, a non-platinum based metal catalyst such as iron, ruthenium, iron/cobalt, or the like may be used.

On the other hand, the hydrosilylation reaction catalyst serving as a part of component (c2) may be a hydrosilylation reaction catalyst (component (c2-1)) which does not exhibit activity without irradiation with the high energy beam below, but exhibits activity in the composition by irradiation with a high energy beam. Component (c2-1) is a so-called high energy beam activated catalyst or photoactivated catalyst, which is known in the present technical field. By using component (c2-1), the composition as a whole can be cured even at low temperatures by irradiation with a high energy beam, has excellent storage stability, and facilitates reaction control, and thus the properties of excellent handling workability can be achieved.

Examples of high energy beams include ultraviolet rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the amount of irradiation varies depending on the type of high energy beam activated catalyst, but in the case of ultraviolet rays, the integrated amount of irradiation at a wavelength of 365 nm is preferably within a range of 100 mJ/cm² to 100 J/cm².

Specific examples of component (c2-1) include (methylcyclopentadienyl) trimethyl platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4-pentanedionato) platinum (II), bis(2,4-hexanedionato) platinum (II), bis(2,4-heptanedionato) platinum (II), bis(3,5-heptanedionato) platinum (II), bis(1 - phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

The amount of the hydrosilylation reaction catalyst, which is a part of component (c2), is preferably an amount in which a metal atom is within a range of 0.01 to 500 ppm, an amount within a range of 0.01 to 100 ppm, or an amount within a range of 0.01 to 50 ppm in terms of mass units relative to the entire composition.

Particularly preferred components (c2) include at least an organohydrogenpolysiloxane resin expressed by the average unit formula described above and a hydrosilylation reaction catalyst.

### [Component (D)]

The curable silicone composition of the present invention may further contain (D) functional filler in addition to components (A1) to (C) above, if imparting functionality to a resulting cured product is desired.

The functional filler, which is component (D), is a component that imparts mechanical or other properties to the cured product, and examples include inorganic fillers, organic fillers, and mixtures thereof. Examples of the inorganic fillers include a reinforcing filler, a white pigment, a thermally conductive filler, an electrically conductive filler, a phosphor, and mixtures of at least two of these, and examples of organic fillers include a silicone resin filler, a fluorine resin filler, and a polybutadiene resin filler. The shape of these fillers is not particularly limited and may be spherical, spindle-shaped, flat, needle-shaped, amorphous, or the like.

When the present composition is used in applications as a sealing agent, a protective agent, an adhesive, and the like, a reinforcing filler can be included in at least a part of component (D) from the perspective of improving the mechanical strength, protection, and adhesion of the cured product.

Reinforcing fillers may be added to improve the mechanical strength of the cured product, to improve protection and adhesion, and to maintain a solid particle shape as a binder filler in the curable silicone composition before curing. Examples of this type of reinforcing filler include fumed silica, precipitated silica, fused silica, calcined silica, fumed titanium dioxide, quartz, calcium carbonate, diatomaceous earth, aluminum oxide, aluminum hydroxide, zinc oxide, and zinc carbonate. These reinforcing fillers may also be surface treated with: organoalkoxysilanes such as methyltrimethoxysilane; organohalosilanes such as trimethylchlorosilane; organosilazanes such as hexamethyldisilazane; siloxane oligomers such as dimethylsiloxane oligomers capped with α,ω-silanol groups, methylphenylsiloxane oligomers capped with α,ω-silanol groups, methylvinylsiloxane oligomers capped with α,ω-silanol groups, or the like. The particle size of the reinforcing filler is not restricted, but the median diameter measured by a laser diffraction scattering type particle size distribution measurement is preferably within a range of 1 nm to 500 µm. Further, as the reinforcing filler, a fibrous filler such as calcium metasilicate, potassium titanate, magnesium sulfate, sepiolite, zonolite, aluminum borate, rock wool, glass fiber, or the like may be used.

Further, a white pigment, a thermally conductive filler, an electrically conductive filler, or a phosphor may be blended for the purpose of imparting other functions to the cured product obtained using the composition. Organic fillers such as silicone microparticles or the like may also be blended for the purpose of improving the stress relief properties of the cured product and the like.

The white pigment is a component that imparts whiteness to the cured product and improves light reflectivity, and the cured product obtained by curing the present composition by blending the component can be used as a light reflective material for light emitting/optical devices. Examples of the white pigment include metal oxides such as titanium oxide, aluminum oxide, zinc oxide, zirconium oxide, magnesium oxide, and the like; hollow fillers such as glass balloons, glass beads, and the like; and additionally, barium sulfate, zinc sulfate, barium titanate, aluminum nitride, boron nitride, and antimony oxide. Titanium oxide has high optical reflectivity and concealing properties, and is therefore preferable. Furthermore, aluminum oxide, zinc oxide, and barium titanate have high optical reflectivity of a UV region, and are therefore preferable. The average particle size or shape of the white pigment is not restricted, but the average particle diameter is within a range of 0.05 to 10.0 µm and preferably within a range of 0.1 to 5.0 µm. Furthermore, surface treatment of the white pigment can be performed using a silane coupling agent, silica, aluminum oxide, and the like.

A thermally conductive filler or an electrically conductive filler is added to the cured product for the purpose of imparting thermal conductivity/electrical conductivity thereto, and specific examples include: a metallic fine powder such as gold, silver, nickel, copper, or aluminum; a fine powder such as ceramic, glass, quartz or organic resin, the surface thereof on which a metal such as gold, silver, nickel, or copper is deposited or plated; a metallic compound such as aluminum oxide, magnesium oxide, aluminum nitride, boron nitride or zinc oxide or the like; and graphite, and mixtures of two or more of these. When electrical insulation is required for the present composition, a metal oxide-based powder or a metal nitride-based powder is preferable, and in particular, an aluminum oxide powder, a zinc oxide powder, or an aluminum nitride powder is preferable and combinations of type, particle diameter, and particle shape and the like can be used according to these thermal conductivity/electrical conductivity requirements.

Phosphor is a component that is blended to convert the emission wavelength from a light source (optical semiconductor device) when the cured product is used as a wavelength conversion material. There are no particular limitations to this phosphor, with examples thereof including yellow, red, green, and blue light phosphors, which include oxide phosphors, oxynitride phosphors, nitride phosphors, sulfide phosphors, oxysulfide phosphors, and the like, that are widely used in light emitting diodes (LED).

Silicone microparticles include non-reactive silicone resin microparticles and silicone elastomer microparticles, but silicone elastomer microparticles are suitably exemplified from the viewpoint of improving cured product flexibility or stress relief properties.

For the purpose of stably blending the functional filler above in the present composition and the like, the filler surface may be treated using a specific surface treatment agent within a range of 0.1 to 2.0 mass%, 0.1 to 1.0 mass%, or 0.2 to 0.8 mass% of the total mass of component (D). Examples of these surface treatment agents include, methylhydrogen polysiloxane, silicone resins, metal soaps, silane coupling agents, perfluoroalkyl silanes, as well as fluorine compounds such as perfluoroalkyl phosphate ester salts.

The amount of component (D) is not limited, but the amount is preferably within a range of 1 to 2,000 mass parts, within a range of 1 to 1,500 mass parts, or within a range of 1 to 1,000 mass parts relative to the sum (100 mass parts) of components (A1) to (C) from the perspective of excellent hardness and mechanical strength of a resulting cured product.

In addition to components (A) to (D) above, the curable silicone composition of the present invention may further contain a curing retarder. The type of the curing retarder is not particularly limited, and examples include: 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl propynyloxy)silane, vinyl tris(1,1-dimethyl propynyloxy)silane, and other alkynyloxysilanes . Of these, compounds with a boiling point of 200°C or higher under atmospheric pressure are particularly preferably used. The amount of the curing retarder in the curable silicone composition is not particularly limited, but is preferably within a range of 10 to 10,000 ppm in mass units, with regard to the composition.

### [Other additives]

In addition to the component described above, a material conventionally known in the field may be added to the curable silicone composition of the present invention as an additive that may be used in a silicone composition, and examples of additives that may be used include, but are not limited to, those described below.

The composition of the present invention may contain an adhesion imparting agent so long as the object of the present invention is not impaired. Such adhesion imparting agents are common to components suitably exemplified by the present applicant in the international patent application (PCT/JP2020/ 12027), and reaction mixtures of epoxy group-containing organoalkoxysilane and amino group-containing organoalkoxysilane disclosed in Japanese Unexamined Patent Application S52-8854 and Japanese Unexamined Patent Application H10-195085, and particularly carbasilatrane derivatives having a silicon-bonded alkoxy group or silicon-bonded alkenyl group in a molecule, silatrane derivatives having an alkoxysilyl group-containing organic group, and the like can be preferably used in addition to 3-glycidoxypropyltrimethoxysilane and other silane compounds, organosiloxane oligomers, and alkyl silicates.

Furthermore, the composition may contain, as other optional components, heat resistance agents such as iron oxide (red iron oxide), cerium oxide, cerium dimethyl silanolate, fatty acid cerium salt, cerium hydroxide, zirconium compound, and the like, with dyes, pigments other than white, flame retardant agents, and the like capable of being contained as long as the purpose of the present invention is not impaired.

The curable silicone composition of the present invention is in a liquid or paste-like form, and therefore can be produced by kneading the aforementioned components (A) to (D) and an optional component by a known method. A mixing device used in mixing or kneading is not limited, and examples include uniaxial or biaxial continuous mixers, two-roll mixers, ROSS mixers, Hobart mixers, dental mixers, planetary mixers, kneader mixers, laboratory mills, small-sized grinders, and Henschel mixers, and preferably, laboratory mills or Henschel mixers.

The curable silicone composition forms a cured product by either thermal curing, high energy beam curing, or high energy beam + thermal curing. Therefore, it is possible to form a cured product while demonstrating adhesion to a base material by applying the composition on or inside the base material to be cured by dispensing or the like prior to the curing process, followed by curing.

### [Use of composition]

The curable silicone composition of the present invention can be used as a liquid at room temperature and has excellent coloring resistance, adhesion to various base materials, and mechanical strength at high temperature of a resulting cured product obtained by curing the present composition at high temperature. Therefore, the composition is useful for applications such as sealing materials for light emitting/optical devices, light reflective materials and other semiconductor members, and optical semiconductors having the cured product. Furthermore, since the cured product has superior mechanical properties, the cured product is suitable as: an encapsulant for semiconductors; an encapsulant for power semiconductors such as SiC, GaN, or the like; and as an adhesive, potting agent, protective agent, and coating agent for electrical and electronic applications. On the other hand, since the hardness of a cured product can be freely controlled by adjusting the composition, compositions that form cured products with relatively soft and rubber elasticity can be used as a stress buffer layer (adhesive layer) between two types of base materials with different coefficients of linear expansion.

Furthermore, the cured product containing the curable silicone composition of the present invention exhibits favorable adhesion to difficult-to-adhere base materials such as polyphenylene sulfone resin, silicone resin, fluororesin, and the like, and can therefore be used for sealing these base materials, as a stress-relief layer to adhere two different base materials, or the like. In other words, the curable silicone composition of the present invention may be a sealing agent for single-sided sealing or for double-sided sealing along with adhesion between two base materials, and have preferred properties suitable for these applications.

### [Curing Conditions of Composition]

As described above, the curable silicone composition of the present invention can use thermal curing, curing with high energy beams such as ultraviolet light or the like, or curing with a combination thereof, depending on the selection of component (C). In the case of thermal curing, exposure to temperatures of 100°C or higher, and preferably 150°C or higher, generally allows curing to rapidly advance. In the case of the high energy beam curing type, after irradiation of the light beam, curing progresses by leaving at room temperature or by heating. Therefore, it is easy to ensure stability as a liquid composition by applying to a base material before irradiating with a high energy beam. After applying to a base material, the present composition can be cured quickly at 25°C or at low temperatures of 100°C or lower by irradiating with a high energy beam.

### [Viscosity of Composition]

The composition of the present invention is characterized by the ability to be handled as a liquid at 25°C, and therefore, the viscosity thereof must be 50 Pa·s or less at a shear rate of 10 (1/s). 30 Pa·s or less is preferred, 10 Pa·s or less is more preferred, and a range of 0.01 to 10 Pa s is particularly preferred. By keeping the viscosity of the composition at or below the range above, it is possible to accommodate processes that require low viscosity.

### [Concentration of Curing Reactive Group Containing Carbon-Carbon Double Bond in Composition]

The composition of the present invention contains curing reactive groups including carbon-carbon double bonds derived from component (A1), component (B), and other components, but in order to make the hardness of a resulting cured product in an elastomer region, the amount of curing reactive groups must be 1.5 mol% or more / 100 g of the composition, and preferably 1.5 to 15.0 mol% / 100 g of the composition. In particular, when the composition of the present invention is cured by a hydrosilylation reaction, the amount of alkenyl groups, which are curing reactive groups, is preferably 1.5 mol% or more per 100 g of the composition. By setting this range at or above the lower limit above, a resulting cured product can have a sufficient crosslinking density and the hardness thereof can be increased.

### [Hardness of Cured Product]

The preferred hardness of the cured product obtained by curing the curable hot melt silicone composition of the present invention is preferably 20 or higher, as measured by a Type A durometer hardness specified in "Durometer Hardness Test Method for Plastics" of JIS K 7215-1986. 30 or higher is more preferred. This is because if the hardness is at or below the lower limit above, the cured product will be too soft and tacky and cannot be used for sealing a base material. On the other hand, if the application is not for sealing a substrate, but rather an adhesive layer to adhere two different base materials, the Type A durometer hardness may be near the lower limit. This is because a lower hardness causes better stress relaxation properties.

### [Use of cured product]

An application of the cured product obtained by curing the curable silicone composition of the present invention is not particularly limited. The composition of the present invention can be handled as a liquid at room temperature, making it suitable for processes that require the composition to be liquid. A resulting cured product exhibits favorable adhesive properties to various base materials and has excellent mechanical strength, and the cured product has low surface tack and hardness in an elastomer region. Therefore, the cured product obtained by curing the present composition can be suitably used as a member for a semiconductor device, and can be suitably used as an encapsulant for a semiconductor element, an IC chip or the like, and as an adhesive/bonding member of a conductor device.

Although semiconductor devices provided with a member containing a cured product obtained by curing the curable silicone composition of the present invention are not particularly limited, in particular, the composition of the present invention can form optically transparent to light reflective or light shielding cured products depending on the presence or absence of component (D), and can be used for different applications. For example, it is preferably a light emitting semiconductor device, which is a light-emitting/optical device, an optical member for a display, or a solar panel member, and particularly preferably a sealing material, case material, or adhesive member used in these devices and the like. Furthermore, the cured product of the present invention has excellent coloring resistance at high temperatures, and therefore is more preferably used as a sealing material, case material, or adhesive member used in electronic materials where transparency and light/heat resistance are important.

### EMBODIMENTS

The curable silicone composition of the present invention and manufacturing method thereof are described below in detail using Embodiments and comparative examples. Note that in the following description, Me, Vi, and Ph in the average unit formula represent methyl, vinyl, and phenyl groups, respectively. Furthermore, the hardness, tensile elongation, surface tack, and adhesion to polyphenylene sulfone resin of the cured product of the curable silicone composition of each embodiment and comparative example were measured by the following methods. The results are shown in Table 1.

Note that the weight average molecular weight (Mw) of the organopolysiloxane resin in each reference example was determined using gel permeation chromatography (GPC) introduced by Waters Corporation, using toluene as a mobile solvent and based on standard polystyrene equivalent.

### Hardness of Cured Product

The curable silicone composition was heated at 150°C for 2 hours to form a cured product. The hardness of the cured product was measured by a type A durometer specified in JISK 7215-1986 "Durometer Hardness Testing Method for Plastics."

### [Tensile Elongation of Cured Product]

The curable silicone composition was heated at 150°C for 2 hours to prepare a cured product. The tensile elongation rate of the cured product was measured using the method specified in JIS K 6251-2010 "Vulcanized Rubber and Thermoplastic Rubber - Determination of Tensile Properties."

### [Surface Tack]

The curable silicone composition was heated at 150°C for 2 hours to prepare a cured product. After placing a PET film on the resulting cured product and applying a load of 50 g/cm² for 10 seconds, the PET film was removed from the cured product. A film that peeled smoothly without adhering was rated as O, a film that strongly adhered and was difficult to peel off was rated as X, and a film that was between ○ and X was rated as Δ.

### [Adhesion to Polyphenylene Sulfone Resin]

A dispenser was used to apply the curable silicone composition on a 25 mm × 75 mm polyphenylene sulfone resin sheet at 5 locations using approximately 100 mg at each location. A 1 mm thick and 6 mm square aluminum chip was placed on the composition, and the assembly was pressure bonded by a 1 kg plate. The assembly was then heated at 150°C for 2 hours to form a cured product. After cooling to room temperature, a die shear test was performed using a shear strength measuring device (Bond Tester SS-100KP manufactured by Seishin Trading Co., Ltd.), and the failure mode was visually observed to determine whether cohesive failure or interface peeling occurred.

The following compounds were used in the Examples and Comparative Example described below.
· Component (a1-1): Organopolysiloxane resin (amount of vinyl groups = 3.1 mol%, weight average molecular weight (Mw) as measured by GPC using toluene as a solvent of 4,300) as expressed by the average unit formula:

   (Me₂ViSiO_{1/2})_{0.08}(Me₃SiO_{1/2})_{0.42}(SiO_{4/2})_{0.50}(HO_{1/2})_{0.01}
. Component (a1-2): Organopolysiloxane resin (amount of vinyl groups = 19 mol%, weight average molecular weight (Mw) as measured by GPC using toluene as a solvent of 1,100) as expressed by the average unit formula:

   (Me₂ViSiO_{1/2})_{0.65}(SiO_{4/2})_{0.35}(HO_{1/2})_{0.01}
. Component (a1-3): Organopolysiloxane resin (amount of vinyl groups = 1.9 mol%, weight average molecular weight (Mw) as measured by GPC using toluene as a solvent of 18,000) as expressed by the average unit formula:

   (Me₂ViSiO_{1/2})_{0.05}(Me₃SiO_{1/2})_{0.39}(SiO_{4/2})_{0.56}(HO_{1/2})_{0.02}
· Component (a2-1): Organopolysiloxane resin (amount of vinyl groups = 0 mol%, weight average molecular weight (Mw) as measured by GPC using toluene as a solvent of 18,500) as expressed by the average unit formula:

   (Me₃SiO_{1/2})_{0.44}(SiO_{4/2})_{0.56}(HO_{1/2})_{0.02}
· Component (a2-2): Organopolysiloxane resin (amount of vinyl groups = 3.1 mol%, weight average molecular weight (Mw) as measured by GPC using toluene as a solvent of 4,300) as expressed by the average unit formula:

   (Me₂ViSiO_{1/2})_{0.08}(Me₃SiO_{1/2})_{0.42}(SiO_{4/2})_{0.50}(HO_{1/2})_{0.01}
**·** Component (b-1): Dimethylpolysiloxane blocked at both molecular terminals with dimethylvinylsiloxy groups (amount of vinyl groups = 0.23 mol%) expressed by

   ViMe₂SiO(Me₂SiO)₃₀₀SiViMe₂
· Component (b-2): Dimethylpolysiloxane blocked at both molecular terminals with dimethylvinylsiloxy groups (amount of vinyl groups = 1.53 mol%) expressed by

   ViMe₂SiO(Me₂SiO)₄₅SiViMe₂
· Component (b-3): Dimethylpolysiloxane blocked at both molecular terminals with dimethylvinylsiloxy groups (amount of vinyl groups = 0.44 mol%) expressed by

   ViMe₂SiO(Me₂SiO)₁₄₀SiViMe₂
· Component (b-4): Dimethylpolysiloxane blocked at both molecular terminals with dimethylvinylsiloxy groups (amount of vinyl groups = 0.09 mol%) expressed by

   ViMe₂SiO(Me₂SiO)₈₀₀SiViMe₂
· Component (c1-1): Organohydrogenpolysiloxane expressed by

   Me₃SiO(Me₂SiO)₃₇(MeHSiO)₃₇SiMe₃
· Component (c1-2): Organohydrogenpolysiloxane expressed by

   HMe₂SiO(Me₂SiO)₁₇SiMe₂H
· Component (c1-3): Organohydrogenpolysiloxane expressed by

   (HMe₂SiO_{1/2})_{0.67}(SiO_{4/2})_{0.33}
· Component (c1-4): Organohydrogenpolysiloxane expressed by

   Me₃SiO(MeHSiO)₅₅SiMe₃
· Component (c2): 1,3-divinyl-1,1,3,3-tetramethyldisiloxane solution of 1,3-divinyl-1,1,3,3-tetramethyldisiloxane of platinum (at an amount where platinum metal is 5.0 ppm in terms of mass units with respect to the present composition)
· Component (d): Titanium oxide (SX-3103 manufactured by Sakai Chemical Industry Co., Ltd.) having an average primary particle diameter of 0.2 µm
· Component (e): 1-ethynylcyclohexanol (at an amount where platinum metal is 50 ppm in mass units with respect to the present composition)
· Component (f): Dimethylpolysiloxane with one end of a molecular chain blocked by a dimethylvinylsiloxy group and the other end of the molecular chain blocked by a trimethoxysiloxy group, expressed by

   Me₂ViSiO(Me₂SiO)₂₉Si(OMe)₃

### [Embodiments 1 to 6 and Comparative Examples 1 to 6]

Curable silicone compositions were prepared by mixing each component in the parts listed in Tables 1 and 2. The viscosity at a shear rate of 10 (1/s) at 25°C, hardness of the cured product, tensile elongation, surface tack, and adhesion to polyphenylene sulfone resin of the cured product are shown in the tables. Note that in Comparative Example 6, the composition was exposed to 150°C for 2 hours and a hot-melt material was obtained, but no cured product was obtained. Therefore, the physical property value of the cured product was set to "NA".

**Table 1-1**

| Component | Embodiment 1 | Embodiment 2 | Embodiment 3 |
|---|---|---|---|
| a1-1 | 28.0 | | |
| a1-2 | | 7.0 | 7.0 |
| a1-3 | | | |
| a2-1 | 29.0 | 40.0 | 40.0 |
| a2-2 | | | |
| b1 | 11.0 | 43.3 | 47.5 |
| b2 | 12.0 | | |
| b3 | | | |
| b4 | | | |
| c1-1 | 3.0 | 9.7 | |
| c1-2 | 17.0 | | |
| c1-3 | | | 5.5 |
| c1-4 | | | |
| c2 (ppm) | 5 | 5 | 5 |
| d | | | |
| e (ppm) | 50 | 50 | 50 |
| f | | | |
| Viscosity (mPa) | 2500 | 4500 | 6700 |
| Hardness (Shore A) | 40.0 | 45 | 42 |
| Tensile elongation (%) | 88.0 | 130 | 120 |
| Surface tack | ○ | ○ | ○ |
| Adhesion | Cohesive failure | Cohesive failure | Cohesive failure |

**Table 1-2**

| Component | Embodiment 4 | Embodiment 5 | Embodiment 6 |
|---|---|---|---|
| a1-1 | 11.8 | 30.0 | 30.0 |
| a1-2 | 3.2 | | |
| a1-3 | | | |
| a2-1 | 34.3 | | |
| a2-2 | | 28.0 | 28.0 |
| b1 | 34.7 | 30.00 | 31.2 |
| b2 | 5.1 | | |
| b3 | | | |
| b4 | | | |
| c1-1 | 7.6 | 4.0 | |
| c1-2 | | 8.0 | 8.00 |
| c1-3 | | | 2.8 |
| c1-4 | | | |
| c2 (ppm) | 5 | 5 | 5 |
| d | 100 | | |
| e (ppm) | 50 | 50 | 50 |
| f | 3.3 | | |
| Viscosity (mPa) | 17000 | 2300 | 3500 |
| Hardness (Shore A) | 81 | 38 | 35 |
| Tensile elongation (%) | 53 | 75 | 70 |
| Surface tack | ○ | Δ | Δ |
| Adhesion | Cohesive failure | Cohesive failure | Cohesive failure |

**Table 2-1**

| Component | Comparative Example 1 | Comparative Example 2 | Comparative Example 3 |
|---|---|---|---|
| a1-1 | | | |
| a1-2 | | | |
| a1-3 | 5.0 | 10.0 | |
| a2-1 | 34.1 | 28.9 | 39.3 |
| a2-2 | | | |
| b1 | 58.6 | 58.3 | 59.0 |
| b2 | | | |
| b3 | | | |
| b4 | | | |
| c1-1 | | | |
| c1-2 | | | |
| c1-3 | 1.5 | 2.1 | 0.97 |
| c1-4 | | | |
| c2 (ppm) | 5 | 5 | 5 |
| d | | | |
| e (ppm) | 50 | 50 | 50 |
| f | | | |
| Viscosity (mPa) | 3300 | 2450 | 4800 |
| Hardness (Shore A) | 18 | 27 | 12 |
| Tensile elongation (%) | 183 | 154 | 318 |
| Surface tack | × | × | × |
| Adhesion | Cohesive failure | Cohesive failure | Cohesive failure |

**Table 2-2**

| Component | Comparative Example 4 | Comparative Example 5 | Comparative Example 6 |
|---|---|---|---|
| a1-1 | | 44.6 | |
| a1-2 | | | |
| a1-3 | | | 37.4 |
| a2-1 | 59.1 | | 37.4 |
| a2-2 | | | |
| b1 | 39.4 | | |
| b2 | | | 5.3 |
| b3 | | 44.5 | |
| b4 | | | 15.3 |
| c1-1 | | 6.25 | |
| c1-2 | | | 4.0 |
| c1-3 | 0.69 | 3 | |
| c1-4 | | | 0.8 |
| c2 (ppm) | 5 | 5 | 5 |
| d | | | |
| e (ppm) | 50 | 50 | 50 |
| f | | | |
| Viscosity (mPa) | 42000 | 3000 | Solid |
| Hardness (Shore A) | 14 | 80 | NA |
| Tensile elongation (%) | 520 | 51 | |
| Surface tack | × | ○ | |
| Adhesion | Cohesive failure | Interfacial peeling | |

### [Summary]

The curable silicone compositions of Embodiments 1 to 6 according to the present invention combine specific organopolysiloxane resins and chain organopolysiloxanes at specific ratios to obtain compositions with viscosities of 50 Pas or lower at 25°C, and cured products thereof were found to exhibit excellent adhesive properties and mechanical strength, and low surface tack with a hardness in an elastomer region of shore A 20 or higher.

On the other hand, the curable silicone compositions of Comparative Examples 1 to 4 have a low concentration of curing reactive groups in the compositions, and resulting cured products are very soft and tacky on the surface, indicating that the products are not suitable in applications of sealing base materials. Furthermore, the curable silicone composition in Comparative Example 5 forms a relatively hard cured product and the surface tack thereof is low, but the adhesive properties thereof are inferior to those of the compositions in the Embodiments. Furthermore, the curable silicone composition in Comparative Example 6 was not liquid at room temperature, and no cured product was obtained even when heat was applied.

## Claims

1. A curable silicone composition, at least comprising:
(A1) an organopolysiloxane resin having a curing reactive functional group with a carbon-carbon double bond included in a molecule, and containing a siloxane unit expressed by RSiO_{3/2} (R represents a monovalent organic group, hydroxyl group or alkoxy group) or SiO_{4/2} making up at least 20 mol% of all siloxane units, at an amount within a range of 1 to 50 mass% relative to the total amount of components (A1), (A2), and (B);
(A2) an organopolysiloxane resin not having a curing reactive functional group with a carbon-carbon double bond included in a molecule, and containing a siloxane unit expressed by SiO_{4/2} making up at least 20 mol% of all siloxane units, at an amount within a range of 20 to 70 mass% relative to the total amount of components (A1), (A2), and (B);
(B) a linear organopolysiloxane in a liquid state at 25°C, having a curing reactive functional group with at least two carbon-carbon double bonds included in a molecule, at an amount within a range of 15 to 70 mass% relative to the total amount of components (A1), (A2), and (B); and
(C) one or more type of curing agent required for curing the present composition, at an amount sufficient for curing the present composition; wherein
the viscosity of the entire composition is 50 Pa s or less, and the amount of curing reactive functional groups containing a carbon-carbon double bond in 100 g of the composition is 1.5 mol% or more.

2. The curable silicone composition according to claim 1, further comprising (D) a functional filler in a range of 1 to 2000 mass parts when the total amount of components (A1) to (C) is 100 mass parts.

3. The curable silicone composition according to claim 1 or 2, wherein component (A1) above is (A1-1) an organopolysiloxane resin as expressed by the following average unit formula:
(R¹₃SiO_{1/2})ₐ(R¹₂SiO_{2/2})_{b}(R¹SiO_{3/2})_{c}(SiO_{4/2})_{d}(R²O_{1/2})ₑ
(where each R¹ independently represents a monovalent hydrocarbon group with 1 to 10 carbon atoms, but 2 to 40 mol% of all R¹s in a molecule represent an alkenyl group; each R² represents a hydrogen atom or an alkyl group with 1 to 10 carbon atoms; and a, b, c, d, and e represent numbers that satisfy 0.10 ≤ a ≤ 0.90, 0 ≤ b ≤ 0.70, 0 ≤ c ≤ 0.80, 0 ≤ d ≤ 0.65, 0 ≤ e ≤ 0.05, but c + d > 0.20 and a + b + c + d = 1).

4. The curable silicone composition according to any one of claims 1 to 3, wherein the weight average molecular weight (Mw) of component (A1) above, as measured by gel permeation chromatography (GPC) using toluene as a solvent, is 15,000 or less.

5. The curable silicone composition according to any one of claims 1 to 4, wherein component (A2) above is (A2-1) an organopolysiloxane resin expressed by the following average unit formula:
(R³₃SiO_{1/2})_{f}(R³₂SiO_{2/2})_{g}(R³SiO_{3/2})ₕ(SiO_{4/2})ᵢ(R²O_{1/2})ⱼ
(where each R³ independently represents a monovalent hydrocarbon group with 1 to 10 carbon atoms and that does not contain a carbon-carbon double bond; R² represents a hydrogen atom with an alkyl group with 1 to 10 carbon atoms; and f, g, h, i, and j represents numbers that satisfy 0.35 ≤ f ≤ 0.70, 0 ≤ g ≤ 0.20, 0 ≤ h ≤ 0.20, 0.30 ≤ i ≤ 0.65, 0 ≤ j ≤ 0.05, and f + g + h + i = 1).

6. The curable silicone composition according to any one of claims 1 to 5, wherein component (B) above is (B1) a linear diorganopolysiloxane expressed by the following structural formula:
R⁴₃SiO(SiR⁴₂O)ₖSiR⁴₃
(where each R⁴ independently represents a monovalent hydrocarbon group with 1 to 10 carbon atoms, but at least two of the R⁴s in one molecule represents an alkenyl group, and k represents a number from 5 to 1,000).

7. The curable silicone composition according to any one of claims 1 to 6, wherein component (C) is an organohydrogenpolysiloxane having at least two silicon-bonded hydrogen atoms in a molecule and a hydrosilylation reaction catalyst; and
the organohydrogenpolysiloxane is included at an amount in which 0.9 to 2.0 mols of silicon-bonded hydrogen atoms is provided per 1 mol of the total amount of carbon-carbon double bonds in the composition of the present composition.

8. A cured product obtained by curing the curable silicone composition according to any one of claims 1 to 7.

9. The cured product according to claim 8, wherein the Shore A hardness is 20 or higher.

10. A semiconductor member, comprising the cured product according to claim 8 or 9.

11. A semiconductor device, comprising the cured product according to claim 8 or 9.
